# EUROPEAN PATENT APPLICATION

(11) **EP 1 005 065 A2**
(43) Date of publication of application: **31.05.2000**
(21) Application number: 99122583.0
(22) Date of filing: 12.11.1999
(51) Int. Cl.: H01L 21/027

(54) **Method of forming wiring pattern**

(30) Priority: 25.11.1998 JP 33400598
(71) Applicant: Murata Manufacturing Co., Ltd., Nagaokakyo-shi Kyoto-fu 617-8555 (JP)
(72) Inventor: Toyota, Yuji, c/o (A170) Intellectual Prop. Dept., Nagaokakyo-shi, Kyoto-fu 617-8555 (JP); Koshido, Yoshihiro, c/o (A170) Intellectual Prop., Nagaokakyo-shi, Kyoto-fu 617-8555 (JP); Fujibayashi, Kei, c/o (A170) Intellectual Prop.Dep, Nagaokakyo-shi, Kyoto-fu 617-8555 (JP); Takahashi, Ryoichiro, c/o (A170) Intellectual Prop, Nagaokakyo-shi, Kyoto-fu 617-8555 (JP); Okawa, Tadayuki, c/o (A170) Intellectual Prop.Dept, Nagaokakyo-shi, Kyoto-fu 617-8555 (JP)
(74) Representative: Gossel, Hans K., Dipl.-Ing.

(57) **Abstract**

A method of forming a wiring pattern (16) which includes the steps of: forming a resist pattern (17) having a shrinkage-inhibiting effect on a substrate (11); releasing gas from the resist pattern (12) by baking the resist pattern; film-forming an electrode material (16a) on the substrate (11) and the resist pattern (12) while the temperature of the substrate is kept lower than the baking temperature of the resist pattern; and removing the electrode material on the resist pattern by separating the resist pattern (12) from the substrate (11).

## Description

### BACKGROUND OF THE INVENTION

### 1. Field of the Invention

The present invention relates to a method of forming a wiring pattern. More particularly, it relates to a method of forming a wiring pattern in which a fine wiring pattern for a wide variety of electronic components, such as semiconductor devices, high frequency integrated circuits, and so forth is formed by a lift-off technology.

### 2. Description of the Related Art

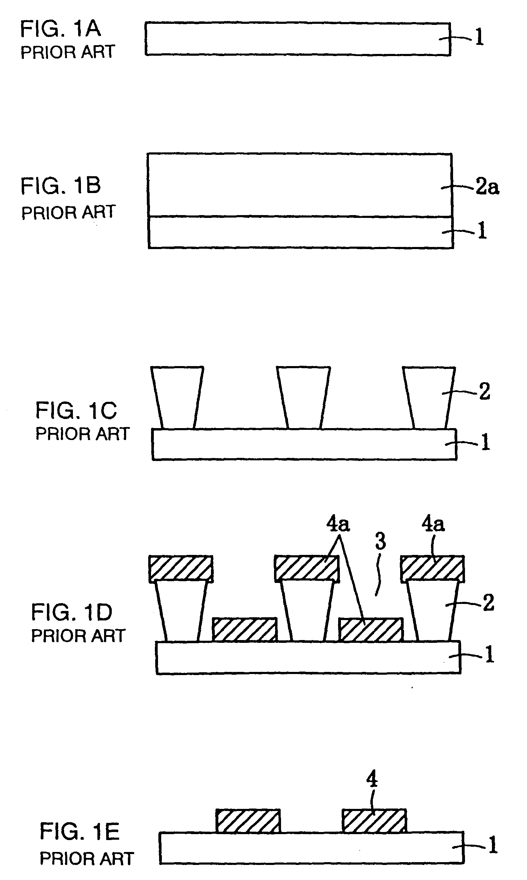

A method of forming a wiring pattern according to the generally used lift-off technology is shown in FIGs. 1A through 1E. In the conventional method of forming a wiring pattern 4 on a substrate 1 (Fig. 1A), after a negative photoresist 2a is applied on the substrate 1 as shown in FIG. 1B, the photoresist 2a is exposed to UV rays (i-rays) through a photomask (not shown). The exposed area of the negative photoresist 2a become insoluble. Accordingly, when the photoresist is developed, the non-exposed area is separated from the substrate 1 with only the exposed area being left, so that a reversely tapered resist pattern 2 as shown in FIG. 1C is formed. Subsequently, an electrode material 4a is applied in a film shape on the substrate 1 through the resist pattern 2 by vapor deposition or sputtering, so that as shown in FIG. 1D, the electrode material 4a is deposited in a film shape on the resist pattern 2, and simultaneously, is passed through the opening 3 of the resist pattern 2 to be deposited on the substrate 1. Thereafter, the substrate 1 is dipped in a separation liquid so that the resist pattern 2 is separated from the substrate 1. The electrode material 4a on the resist pattern 2 is separated together with the resist pattern 2, whereby a wiring pattern 4 as shown in FIG. 1E is obtained.

In a wiring pattern formation process as described above, in consideration of the lift-off performance of the electrode material 4a (that is, in order that the electrode material 4a on the resist pattern 2 and the electrode on the substrate 1 are completely separated), the thickness of the photoresist 2a is set at a larger value than a desired wiring pattern film thickness, and as a film forming process, a vapor deposition method in which the vertical incident performance for particles is high, or a low pressure sputtering method in which the vertical incident performance is enhanced by lengthening the base - target distance, and so forth, are employed. Moreover, the resist pattern 2 is distorted, caused by the heat damage at a temperature of about 140°C. The distortion of the resist pattern 2 as described above deteriorates the lift-off performance of the electrode material 4a remarkably, and reduces the pattern accuracy of the wiring pattern 4. Accordingly, when the wiring pattern 4 is film-formed, ordinarily, the film-formation is carried out without heating of the substrate.

However, in the case that a wiring pattern having a thickness exceeding 2 µm is formed, it takes a relatively long time to form the film. Accordingly, even though the substrate is not heated during film-formation, the temperature of the substrate is raised to about one hundred to several dozens °C - 200°C, because it is affected by radiation heat from a crucible and a target, plasma, and so forth, generated when the film is formed, so that the resist pattern is damaged or distorted. In addition, for the film-forming particles themselves, the grain growth becomes vigorous, due to the rise of the temperature, so that the dimensional precision of the wiring pattern is deteriorated. Further, the electrode material on the photoresist and that on the substrate are brought into contact to each other, due to the growth of grains, and it becomes difficult to lift off the electrode material on the photoresist.

On the other hand, since the resist pattern has a large thickness (not less than 2 µm), gas is released from the resist pattern, caused by the rise of the temperature when the electrode material is formed into a film, so that resist itself is ready to be shrunk or distorted. This shrinkage or distortion of the resist pattern affects the dimensional accuracy of the wiring pattern. Further, the release of gas from the resist pattern reduces the vacuum degree in a film-forming apparatus, so that the film-forming particles are scattered or turned to the side of the photoresist. Thus, the electrode material on the photoresist can not be lifted off.

As regards only the temperature rise caused during film-formation of the electrode material, the temperature rise can be avoided by repeating the procedure in which the film-formation is intermittently stopped, and the film is left to stand for cooling, and thereby, a thick film pattern can be formed. However, it requires a great processing time, which is a problem for the practical application.

### SUMMARY OF THE INVENTION

The present invention can solve the aforementioned problems of the conventional art associated with the lift-off technology and realize the formation of a wiring pattern with a higher accuracy by the lift-off technology.

The method of forming a wiring pattern comprising the steps of: forming a resist pattern having a shrinkage-inhibiting effect on a substrate; releasing gas from the resist pattern by baking the resist pattern; film-forming an electrode material on the substrate and the resist pattern while the temperature of the substrate is kept lower than the baking temperature of the resist pattern; and removing the electrode material on the resist pattern by separating the resist pattern from the substrate.

For the purpose of illustrating the invention, there is shown in the drawings several forms which are presently preferred, it being understood, however, that the invention is not limited to the precise arrangements and instrumentalities shown.

### BRIEF DESCRIPTION OF THE DRAWINGS

FIGS. 1A through 1E show the process of forming a wiring pattern according to a conventional lift-off method.
FIGS. 2A through 2F show the process of forming a wiring pattern according to an embodiment of the present invention.
FIG. 3 is a plan view of a photomask used in the photolithography process of the above embodiment.
FIG. 4 is a cross sectional view showing a vacuum deposition apparatus in outline, used in the film-forming process of the same embodiment.
FIGS. 5A through 5F show the process of forming a wiring pattern according to another embodiment of the present invention.
FIG. 6 is a plan view showing a resist pattern formed on the surface of the substrate in the step of FIG. 5B.
FIG. 7 is a cross sectional view showing a parallel flat sheet sputtering apparatus in outline, used in the film-forming process of the above embodiment.

### DETAILED DESCRIPTION OF PREFERRED EMBODIMENTS

According to a preferred embodiment of the present invention, the method of forming a wiring pattern comprises the steps of forming a resist pattern having a shrinkage-inhibiting effect on a substrate, releasing gas from the resist pattern by baking the resist pattern, film-forming an electrode material on the substrate and the resist pattern while the temperature of the substrate is kept lower than the baking temperature of the resist pattern, and removing the electrode material on the resist pattern therefrom by separating the resist pattern from the substrate.

In the method, the resist pattern, which has a shrinkage-inhibiting effect, is inhibited from shrinking during baking and so forth of the resist pattern. This enables the pattern precision of the wiring pattern to be enhanced. Further, according to the present invention, after the resist pattern is baked, the electrode material is formed into a film at a substrate temperature lower than the baking temperature. Accordingly, the release of gas from the resist pattern during film-formation of the electrode material is inhibited, and flying particles formed with the electrode material to be deposited on the substrate are inhibited from scattering which may be caused by the gas released from the resist pattern. Thus, the pattern precision of the wiring pattern can be enhanced.

Further, before the electrode material is film-formed, the resist pattern is baked previously so that gas is released sufficiently. Accordingly, the release of gas from the resist pattern is inhibited during film-formation of the electrode material, and thereby, the flying particles formed with the electrode material are prevented from being turned to reach the side of the resist pattern. Thus, the lift-off performance presented when the wiring pattern is formed by the lift-off technology is not deteriorated. Further, since the substrate temperature during film-formation is lower than the baking temperature of the resist pattern, the grain growth of the electrode material to be film-formed on the substrate can be inhibited. That is, the deterioration of the lift-off performance and the reduction of the wiring pattern precision, caused by the grain growth, can be prevented.

As a result, according to the present invention, the electrode material formed on the resist pattern and that deposited in the opening of the resist pattern can be securely separated. The electrode material deposited on the resist can be lifted off without failure. The formation of a wiring pattern by the lift-off technology is enabled. Further, the pattern precision of the wiring pattern is enhanced.

In the method of forming a wiring, the baking temperature of the resist pattern is preferably from 100°C to 120°C, and the substrate temperature during film-formation of the electrode material is preferably up to 100°C.

When the baking temperature of the resist pattern is lower than 100°C, gas can not be released sufficiently from the resist pattern. When the temperature is higher than 120_C, there is the danger that the heat will distort the resist pattern. The substrate temperature during film-formation of the electrode material, if it is higher than 100°C, may become higher than or near to the baking temperature. Accordingly, it is possible that the gas remaining in the resist is released therefrom. Accordingly, it is desirable that the baking temperature of the resist pattern is from 100°C to 120°C. In addition, desirably, the substrate temperature at formation of the electrode material is up to 100°C.

In the method, the baking of the resist pattern may be carried out in a reduced-pressure environment. It is necessary to release the gas sufficiently during baking of the resist pattern so that in the subsequent film-forming step the gas is not released. Ordinarily, the baking is carried out in an atmospheric pressure. In the case where the baking is conducted in the state that the pressure in the surroundings of the substrate is reduced, the gas release from the resist pattern can be accelerated.

A holder or a piece supporting the substrate in the step of film-forming the electrode material may be provided with a cooling device. If the substrate can be cooled through the substrate-supporting piece, the substrate temperature is prevented from rising during film-formation. Thus, the gas release from the resist pattern and the grain growth of the film-forming particles, caused by the rising of the substrate temperature, can be inhibited. The lift-off performance and the pattern precision can be further enhanced.

Alternatively, a material having a high heat capacity may be provided on the back of the substrate in the step of film-forming the electrode material. The material with a high heat capacity, provided on the back of the substrate, acts as a heat sink, which prevents the temperature of the substrate from rising. The gas release from the resist pattern and the grain growth of film-forming particles, caused by the rising of the substrate temperature, can be inhibited. The lift-off performance and the pattern precision can be further enhanced.

The resist pattern having a shrinkage-inhibiting effect can be obtained by minimizing the volume of the resist pattern as the amount of gas released from the resist pattern can be reduced in accordance with the reduction of the volume.

For example, the resist pattern may be rendered a shrinkage-inhibiting effect by exposure through a photomask with a pattern having a width not more than the resolution limit, and forming concavities in the surface of the resist pattern for inhibition of the resist shrinkage.

The exposure becomes insufficient when it is carried out through the photomask having a pattern width not more than the resolution limit, so that grooves or concavities can be formed in the surface of the resist pattern, not reaching the back side thereof. Thus, the pattern which has a reduced volume and a resist shrinkage inhibiting effect can be formed in the simple way. Further, the gas release surface can be enlarged by the increase of the resist pattern surface. Accordingly, the gas release can be made more active, and correspondingly, the release of the residual gas during film-formation of the electrode material can be inhibited.

Alternatively, the resist pattern is rendered a shrinkage-inhibiting effect by forming the resist pattern so as to surround a wiring pattern forming area on the substrate.

When the resist pattern is formed so as to surround a wiring pattern forming area on the substrate, the resist pattern area can be substantially minimized, and thereby, the amount of gas released from the resist pattern can be reduced, and the distortion and shrinkage of the resist pattern can be lessened. In this case, the electrode material is deposited in an area other than the wiring pattern forming area. Accordingly, the unnecessary electrode material is removed in a post-process.

Hereinafter, the preferred embodiments of the present invention are explained in more detail with reference to the drawings.

### (First Embodiment)

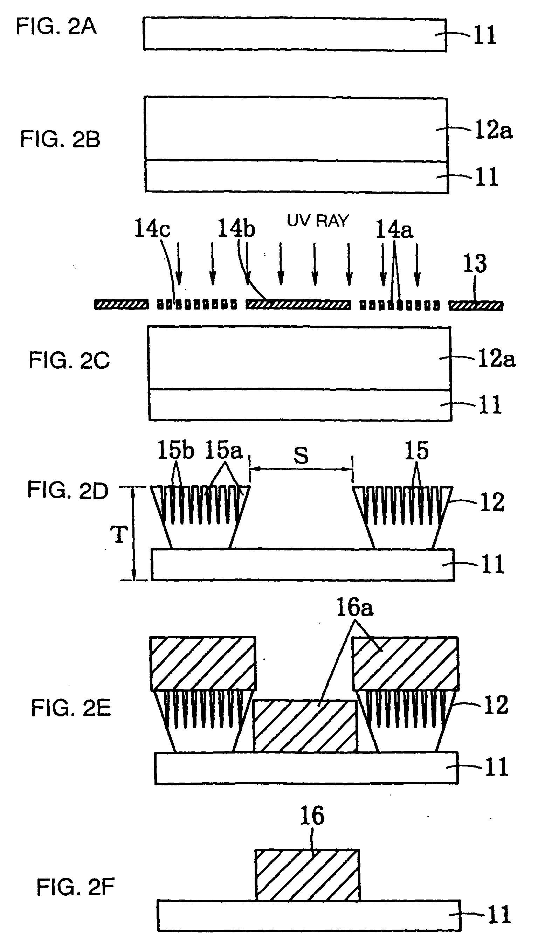

FIGS. 2A through 2F are drawings illustrating a method of forming a wiring pattern according to an embodiment of the present invention. This embodiment uses a (Zr, Sn) TiO₄ (ZrₓSn₁₋ₓTiO₄) substrate 11 (FIG. 2A). On the substrate 11, a photosensitive chemical-amplification type negative resist 12a (ZPN-1100: manufactured by Nippon Zeon Co., Ltd.) is spin-coated at 2000 rpm to have a film thickness of 5 µm, and prebaked on a hot plate at 90°C for 90 seconds (FIG. 2B).

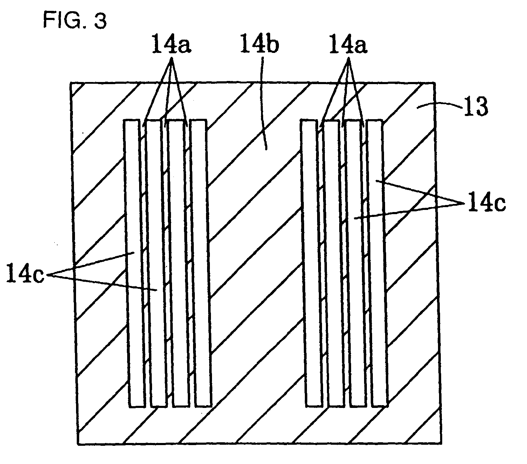

Subsequently, the resist 12a formed on the substrate 11 was exposed to ultra-violet rays (i-rays) through a photomask 13 (FIG.2C) . In this case, an over-exposure as compared with an ordinary one is employed. The photomask 13 used there, as shown in FIG. 3, includes a shading pattern 14b (shown by slanted lines) formed in an area where the resist 12a is to be removed, and having a line width (5 - 200 µm) not less than the resolution limit of the exposure light, and a shading pattern 14a for forming grooves, as described in more detail later, having a line width (1 µm) not more than the resolution limit. For exposure, a 1/5 reduction projection-exposing apparatus (step & repeat system) was used. The exposure was 80 mJ/cm².

Then, the substrate 11 was placed in a vacuum tank with a heater, baked at a vacuum of 2 × 10⁻³ Pa or lower at 100°C for 10 minutes, developed with an alkaline developer, washed, and dried with an N₂ blow, resulting in the formation of a resist pattern 12 on the substrate 11 (FIG. 2D). In this case, the resist pattern 12 formed on the substrate 11 is composed of three type states, that is, " an area where the resist 12a is resolved completely" (in correspondence to the above-described shading pattern 14b), " an area 15a where the resist 12a is not resolved at all "(in correspondence to the light-transmittable portion 14c of the photomask 13)), and "an area 15b where the resist 12a is not completely resolved and is dissolved partially" (in correspondence to the above-described shading pattern 14a).

The area where the resist 12a is completely resolved and removed is the area where UV rays are completely interrupted by the shading pattern 14b of the photomask 13 having a line width not less than the resolution limit. The area 15a where the resist 12a is not resolved at all is the area exposed through the light-transmittable portion 14c of the photomask 13. The area 15b where the resist 12a is not completely resolved and is partially dissolved is the area where UV rays are interrupted by the shading pattern 14a having a line width not more than the resolution limit of the UV rays. The area is formed to have a comb-shape including deep, narrow grooves of which the depth does not reach the substrate 11, and the surface has a wave-form (hereinafter, the wave-form pattern composed of the deep, narrow grooves not perforated to the back side will be referred to as a dummy pattern). This produced resist pattern 12 has a reversely tapered shape. The thickness T is 5 µm, and the opening width S on one side is 400 µm.

As in this embodiment, by forming the shading pattern 14a having a line width not more than the resolution limit in the area which should be exposed originally, and irradiating UV rays to dissolve the resist 12a partially, so that the exposure area has a comb shape in cross-section, to form the dummy pattern, the volume of the resist pattern 12 can be reduced as compared with a usual resist pattern. Thus, the amount of gas released from the resist pattern 12 can be reduced. In addition, the shrinkage and distortion of the resist pattern 12, caused by degassing from the resist pattern 12, can be reduced. The resist pattern has a shrinkage-inhibiting effect, attributed by the presence of the dummy pattern. Moreover, since the dummy pattern having a comb shape in cross-section is formed in the surface of the resist pattern 12 so that the surface area of the resist pattern 12 is increased, the release area for gas of the resist pattern 12 is increased. Further, in the baking process of the resist pattern 12, the resist pattern 12 is heated at a relatively high temperature. Therefore, the gas can be completely removed from the resist pattern 12 in the baking process. As described above, the absolute amount of gas released from the resist pattern 12 is decreased, and the gas is removed from the resist pattern 12 completely in the baking process. Accordingly, the amount of gas released from the resist pattern 12 in the subsequent electrode material film-forming process can be remarkably reduced.

Desirably, the baking process is carried out in a reduced pressure atmosphere. By baking in a reduced pressure atmosphere, the released gas can be prevented from being saturated, and the gas release from the resist pattern 12 in the baking process can be accelerated.

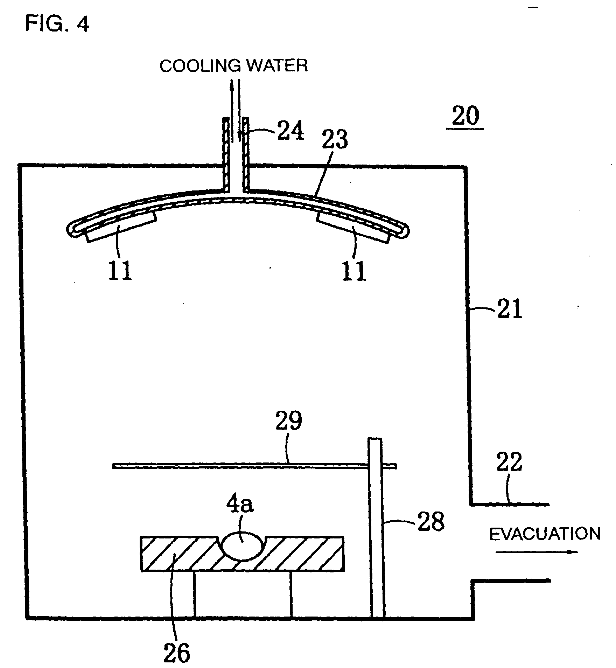

Thereafter, the substrate 11 was placed in a vacuum vapor deposition apparatus 20 provided with a water-cooling type substrate holder 23. FIG. 4 shows the vacuum vapor deposition apparatus 20 in outline. The vacuum tank 21 is provided with an evacuation passage 22 through which the gas in the vacuum tank 21 is forced to be discharged. On the floor of the vacuum tank 21, a crucible 26 for heating an electrode material to evaporate is disposed, and on the ceiling, a substrate holder 23 is provided. In the substrate holder 23, a water circulation passage 24 is provided, so that the substrate holder 23 can be forcedly cooled by circulation of cooling water wholly in the substrate holder 23. A plurality of the substrates 11 with the sides thereof having the resist patterns formed thereon being faced downward can be attached to the underside of the substrate holder 23. The substrates 11 attached to the substrate holder 23 are arranged in opposition to the crucible 26. Further, a shutter 29 supported by a supporting column 28 is disposed between the crucible 26 and the substrate holder 23. The shutter 29 is closed so as to interrupt the evaporation particles of the electrode material 27 heated in the crucible 26, or is opened so that the passage for the evaporation particles between the crucible 26 and the substrate holder 23 is opened.

Thus, after the substrates 11 were set on the substrate holder 23, Ti and Cu in the crucibles 26 were heated with electron beams (not shown). While the shutter 29 for the crucible 26 containing Cu therein was closed, the shutter 29 for the crucible 26 containing Ti therein was opened, so that the evaporation particles were deposited on the surface of the substrates 11 to form a Ti film having a thickness of 50 nm. Subsequently, while the shutter 29 for the crucible 26 containing Ti therein was closed, the shutter 29 for the crucible 26 containing Cu therein was opened, so that the evaporation particles were deposited on the surface of the substrates 11 to form a Cu film having a thickness of 4 µm. In this case, since the substrate holder 23 was cooled with cooling water, the maximum substrate temperature could be controlled to be 95°C.

As described above, an electrode material 16a (Ti/Cu) composed of the lower layer made of Ti with a thickness of 50nm, and the upper layer made of Cu with a thickness of 4 µm was film-formed by vapor deposition (FIG.2E) , and thereafter, the substrate 11 was dipped in acetone, so that the Ti/Cu film on the resist pattern 12 together with the resist pattern 12 was separated, whereby a desired fine wiring pattern 16 (Cu microstrip line) was obtained (FIG. 2F).

The resist pattern 12 formed on the surface of the substrate 11 has a seduced volume caused by the dummy pattern, so that the absolute amount of gas released from the resist pattern 12 is reduced as compared with an ordinary resist pattern. In addition, the surface area through which gas is released is increased due to the dummy pattern. Accordingly, during baking of the resist pattern 12, gas can be completely removed from the resist pattern 12. Further, since in this film-forming process, the substrate temperature is lower than the baking temperature, substantially no gas is released from the resist pattern 12 from which gas has been completely removed in the baking process.

Accordingly, in the process where the electrode material 16a for a wiring pattern is vapor deposited, a high vacuum can be maintained in the vacuum tank 21, and the vapor deposition particles are inhibited from colliding with the gas particles and scattering. Thus, the evaporation particles can be inhibited from being turned to reach the side of the resist pattern 12. The connection of the electrode material 27 deposited on the resist pattern 12 to the electrode material 27 on the substrate 11, caused by the evaporation particles turned to the side, can be prevented. Moreover, since the substrate 11 can be cooled during film-formation so that the temperature of the substrate 11 is kept low, the grain growth of the electrode material 27 can be inhibited, and thereby, the connection of the electrode material 27 deposited on the resist pattern 12 to the electrode material 27 on the substrate 11, caused by the evaporation particles turned to the side, can be also prevented. Accordingly, the formation of the wiring pattern 16 by the lift-off technology is realized.

Further, since the temperature of the substrate can be kept low by cooling, the heat damage of the resist pattern 12 can be inhibited. As described above, the distortion of the resist pattern 12 caused by the gas release and that caused by the heat damage can be inhibited. Accordingly, the pattern precision of the wiring pattern 16 formed by use of the resist pattern 12 can be enhanced.

The resist used in this embodiment is not limited to the chemical amplification type negative resist. Any kind of a resist is available on the condition that it realizes such a shape as can be lifted off. The exposure system is not limited to the reduction projection exposure. Any exposure system gives a similar effect if it is a technique by which a desired resolution can be obtained. The film-forming method is not limited to the vapor deposition. Any system can be used if it is a technique by which the lift-off is possible. The substrate material and the wiring materials are not limited to those described above. Other different types of materials can be applied.

### (Second Embodiment)

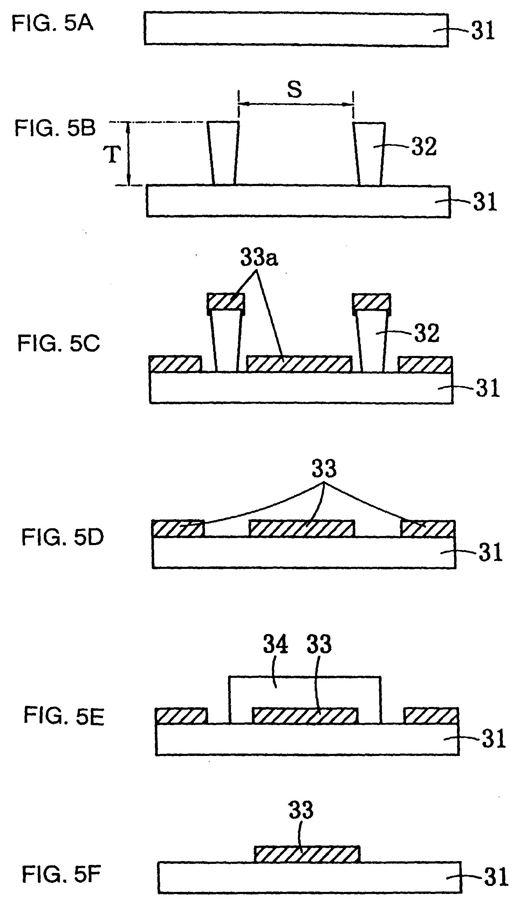

FIGS. 5A through 5F are drawings illustrating a method of forming a wiring pattern according to another embodiment of the present invention using a sapphire substrate 31 (Fig. 5A). First, on the substrate 31, a positive type resist (AZ1500: manufactured by Clariant) was spin-coated. Then, the resist was patterned by the photolithograpy using a chlorobenzene technique, so that a resist pattern 32 having a reversely tapered shape in cross-section, with a thickness T of 3 µm and an opening width S on one side of 200 µm was formed (FIG. 5B). In this photolithographic process, as the exposure source, h rays (405 nm) were used. The exposure was 120 mJ/cm². The liquid temperature of chlorobenzene was 30°C. The substrate 31 having the resist was dipped for 15 minutes.

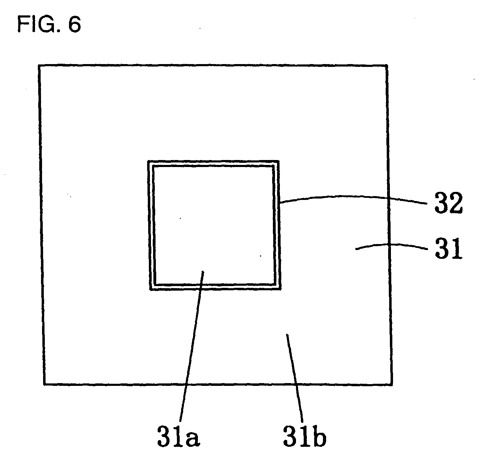

FIG. 6 shows a plan view of the pattern of the resist pattern 32 (the width of the resist pattern 32 shown in FIG. 5 is wider than that of the resist pattern 32 shown in FIG. 6). In the resist pattern 32 generally produced by the lift-off technology, only an electrode-forming area is opened, and in the other area, the resist pattern 32 is left. However, in this embodiment, in the electrode forming area 31a, the resist pattern 32 is opened, and simultaneously, the resist pattern 32 is left to surround the electrode forming area 31a in a thin width thereof. In the other area 31b (including the area where no electrode is formed), the resist pattern 32 is opened or removed. In this manner, the resist pattern 32 having the structure in which the area and the volume of the resist pattern 32 are extremely reduced can be attained. Desirably, the width of the resist pattern 32 is set as small as possible in the range that no collapse of the pattern, caused by a reduction in its strength, occurs.

Subsequently, the substrate 31 was placed on a hot plate, and baked at 120°C for 10 minutes. In this case, gas was sufficiently released from the resist pattern 32.

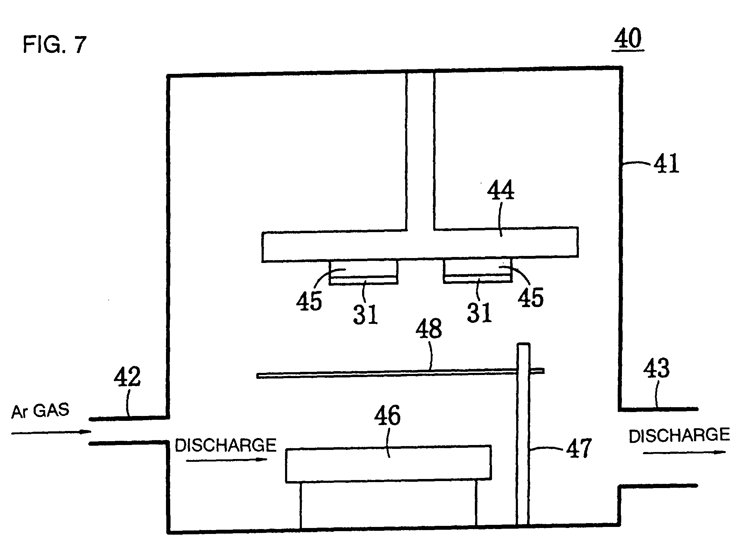

Then, the substrate 31 was set in a parallel flat sheet sputtering apparatus 40. FIG. 7 shows in outline the parallel flat sheet sputtering apparatus 40 used in this case. In a vacuum tank 41, a gas feeding passage 42 through which Ar gas is flown at a constant flow rate, and a gas discharge passage 43 for discharging the gas inside thereof, forcedly, are provided. On the floor of the vacuum tank 41, a target 46 which is an electrode material 33a is disposed. Above the target 46, a substrate holder 44 (electrode portion) is provided. Plural sheets of the substrates 31 are set on the underside of the substrate holder 44 in such a manner that each substrate and the underside of the substrate holder 44 sandwich a heat sink 45 made of a Cu sheet with a thickness of 10 mm. Further, a shutter 48, supported by a supporting column 47, is disposed between the target 46 and the substrate holder 44.

After the substrates 31 were set onto the substrate holder 44, a Ti film with a film thickness of 100 nm was deposited on each substrate 31 by use of Ti as the target 46. Then, an Au film with a film thickness of 2 µm was deposited on the Ti film by use of Au as the target 46 (FIG. 5C). The maximum temperature of the substrate during the film-formation was controlled to be 86°C. Since the area of the resist pattern 32 is reduced as much as possible, the amount of gas released from the resist pattern 32 is extremely decreased. Moreover, since the temperature of the substrate during the film-forming is lower than the baking temperature (120°C) of the resist pattern 32, the release of the gas from the resist pattern 32 can be inhibited. In addition, since the heat sink 45 is disposed on the underside of the substrate 31, heat from the substrate 31 is absorbed by the heat sink 45 so that the temperature of the substrate 31 is inhibited from rising. Accordingly, the distortion or shrinkage of the resist pattern 32 during film-formation can be reduced, and deficiencies in the film-formation of the electrode material 33a, caused by the release of gas, can be prevented.

As described above, after the electrode material 33a of Ti/Au was film-formed, the substrate 31 was dipped in an organic solvent to separate the resist pattern 32, whereby the electrode material 33a on the resist pattern 32, together with the resist pattern 32 was lifted off (FIG. 5D). Subsequently, the resist was coated again on the surface of the substrate 31. The resist on the substrate 31 was patterned to form a resist pattern 34 in such a manner that it coated only the electrode material 33a finally required as a wiring pattern (FIG. 5E). Etching was carried out in the state that the necessary electrode material 33a was coated with the resist pattern 34, so that the unnecessary electrode material 33a exposed from the resist pattern 34 was separated, whereby a desired wiring pattern (Au bonding pad)33 was produced.

In this embodiment, the resist pattern 32 is baked at a temperature higher than that of the substrate at film-formation, before the electrode material 33a is film-formed, so that the release of gas from the resist pattern 32 is carried out prior to film-formation. Accordingly, the release of gas at film-formation is prevented, and the film-forming particles can be inhibited from turning to the side of the resist pattern 32. Further, since the area of the resist pattern 32 is decreased, the shrinkage and distortion of the resist pattern 32, caused by the gas release during baking, can be inhibited. Moreover, since the material (heat sink 45) with a high heat capacity is attached to the substrate 31 at film-formation, the rising of the temperature at film-formation can be inhibited, and the heat damage to the resist pattern 32 and the grain growth of film-forming particles can be prevented, which improves the lift-off performance. In this embodiment, the wiring pattern 33 with a high precision can be formed by the lift-off technology, due to the cooperation of the above-described effects.

While preferred embodiments of the invention have been disclosed, various modes of carrying out the principles disclosed herein are contemplated as being within the scope of the following claims. Therefore, it is understood that the scope of the invention is not to be limited except as otherwise set forth in the claims.

## Claims

1. A method of forming a wiring pattern comprising the steps of:
forming a resist pattern having a shrinkage-inhibiting effect on a substrate;
releasing gas from the resist pattern by baking the resist pattern;
film-forming an electrode material on the substrate and the resist pattern while the temperature of the substrate is kept lower than the baking temperature of the resist pattern; and
removing the electrode material on the resist pattern by separating the resist pattern from the substrate.

2. A method of forming a wiring pattern according to Claim 1, wherein the baking temperature of the resist pattern is from 100°C to 120°C, and the temperature of the substrate at film-forming of the electrode material is less than 100°C.

3. A method of forming a wiring pattern according to Claim 1 , wherein the baking of the resist pattern is carried out in a reduced-pressure environment.

4. A method of forming a wiring pattern according to Claim 1, wherein a cooling means is provided for a piece supporting the substrate in the step of film-forming the electrode material.

5. A method of forming a wiring pattern according to Claim 1, wherein a material having a high heat capacity is provided on the back of the substrate in the step of film-forming the electrode material.

6. A method of forming a wiring pattern according to Claim 1, wherein the resist pattern having a shrinkage-inhibiting effect is that in which the volume is minimized.

7. A method of forming a wiring pattern according to Claim 6, wherein the shrinkage-inhibiting effect is provided by exposure through a photomask to light with a pattern having a width not more than the resolution limit of the light, and by forming concavities at the surface of the resist pattern.

8. A method of forming a wiring pattern according to Claim 6, wherein the shrinkage-inhibiting effect is provided by forming the resist pattern so as to surround a wiring pattern firming area on the substrate.
